# EUROPEAN PATENT APPLICATION

(11) **EP 1 473 974 A1**
(43) Date of publication of application: **03.11.2004**
(21) Application number: 03706914.3
(22) Date of filing: 05.02.2003
(51) Int. Cl.: H05B 33/04, H05B 33/10, H05B 33/14

(54) **COVER FILM FOR ORGANIC ELECTROLUMINESCENCE DEVICE, ORGANIC ELECTROLUMINESCENCE DEVICE COMPRISING SAME, AND ITS MANUFACTURING METHOD**

(30) Priority: 08.02.2002 JP 2002032346
(71) Applicant: ZEON CORPORATION, Chiyoda-ku Tokyo 100-8323 (JP)
(72) Inventor: KASHIWAGI, Motofumi, c/o ZEON CORPORATION, Chiyoda-ku, Tokyo 100-8323 (JP); TANAKA, Kimiaki, c/o ZEON CORPORATION, Chiyoda-ku, Tokyo 100-8323 (JP)
(74) Representative: VOSSIUS & PARTNER
(86) International application number: PCT/JP2003/001202
(87) International publication number: WO 2003/067932

(57) **Abstract**

A cover film for organic electroluminescence (EL) devices which comprises polymers of decomposition products of a perfluoroolefin and has an average light transmittance of 70% or larger in a wavelength band of 400 to 800 nm; an organic EL device which comprises at least an electrode layer (an anode), a layer of a light emitting substance, a transparent electrode layer (a cathode) and the above cover film for an organic EL device which are laminated successively on a substrate; and a process for producing an EL device which comprises forming the cover film in accordance with the plasma CVD process using a material gas containing the perfluoroolefin as the main component.

## Description

### TECHNICAL FIELD

The present invention relates to a cover film for organic electroluminescence ("electroluminescence" will be referred to as "EL", hereinafter) devices, an organic EL device using the cover film and a process for producing the organic EL device. More particularly, the present invention relates to a cover film for organic EL devices which comprises polymers of decomposition products of a perfluoroolefin and has an excellent transparency, an organic EL device which is sealed with the cover film disposed on the surface and emits light mainly at the side of the cathode and a process for efficiently producing the organic EL device.

### BACKGROUND ART

EL devices which utilize light emission under application of an electric field show excellent self-distinguishability due to the self-emission and exhibit excellent impact resistance since they are completely solid devices. Therefore, EL devices have been attracting attention for application as light emitting devices in various types of display apparatus.

The EL devices include inorganic EL devices in which an inorganic compound is used as the light emitting material and organic EL devices in which an organic compound is used as the light emitting material. Organic EL devices have been extensively studied for practical application as a light emitting device of the next generation since the applied voltage can be decreased to a large extent, the size of the device can be reduced easily, consumption of electric power is small, planar light emission is possible, and three primary colors are easily emitted.

As for the construction of the portion of a light emitting substance of the organic EL device, in general, the basic construction comprises a transparent electrode layer (an anode), a layer of a thin film of an organic light emitting substance (an organic light emitting layer) and a metal electrode layer (a cathode), which are successively formed on a transparent substrate. Constructions having a hole injecting and transporting layer or an electron injecting layer suitably added to the basic construction are known. Examples of such constructions include the construction of an anode / a hole injecting and transporting layer / an organic light emitting layer / a cathode and the construction of an anode / a hole injecting and transporting layer / an organic light emitting layer / an electron injecting layer / a cathode. The hole injecting and transporting layer has the function of transporting holes injected from the anode. The electron injecting layer has the function of transporting electrons injected from the cathode to the light emitting layer. It has been known that, due to the hole injecting and transporting layer disposed between the light emitting layer and the anode, a larger amount of holes are injected into the light emitting layer under a lower electric field, and electrons injected into the light emitting layer from the cathode or the electron injecting layer are accumulated at the interface between the hole injecting and transporting layer and the light emitting layer to increased the efficiency of the light emission since the hole injecting and transporting layer does not transport electrons.

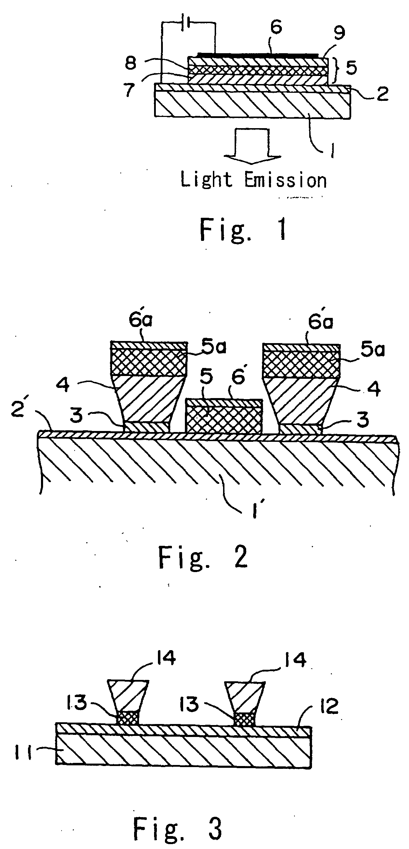

Figure 1 shows a diagram exhibiting the principle of an example of the organic EL device. As shown in this Figure, an organic EL device has, in general, a construction in which an organic EL material layer 5 having a hole injecting and transporting layer 7, an organic light emitting layer 8 and an electron injecting layer 9 is laminated to a transparent electrode (the anode) 2 disposed on a transparent substrate 1, and a metal electrode layer (the cathode) 6 is further laminated to the organic EL material layer 5. When the electric current flows between the anode and the cathode, light is generated in the organic light emitting layer 8 and emitted to the outside through the transparent substrate 1 in the above construction.

Recently, it is attempted that the emitted light is obtained at the side of the cathode using a transparent electrode as the cathode. Obtaining the emitted light at the side of the cathode has advantages in that (1), since a transparent device can be prepared by using a transparent cathode in combination with a transparent anode and any desired color can be used for the background, a colorful display can be obtained, exhibiting an improved decorative property, even when the light is not emitted, and the contrast can be improved by using black color as the background when the light is emitted; and (2), when layers such as a color filter and a color conversion layer are used, the device can be produced without taking these layers into consideration since these layers can be placed on the light emitting device.

The organic EL device is a light emitting device driven by the electric current, and a large electric current must flow between the anode and the cathode for emission of light. As the result, heat is generated in the device during the light emission and, when oxygen and water are present around the device, oxidation of the materials constituting the device is promoted with oxygen and water to degrade the device. Typical examples of the problem caused by the degradation of the organic EL device with oxygen and water include formation and growth of dark spots. The dark spot means the point of defect in light emission. When the oxidation of the materials constituting the organic EL device proceeds during the use of the device, the dark spots already formed grow, and the undesirable phenomenon takes place in that the dark spots expand to the entire face of the light emission.

Various methods have been attempted to overcome the above problems. For example, a sealing can made of glass, a plastics or a metal is attached to the substrate of an organic EL device with an adhesive, and the inside of the can is filled with a gas such as nitrogen gas containing barium oxide exhibiting the effect of absorbing moisture or an inert liquid exhibiting little effects on the organic EL device so that a sealing layer is formed.

However, when the sealing layer is formed with a can filled with the gas, a problem arises in that cracks tend to be formed due to the change in the volume of the gas depending on the temperature of the environment, and there is the possibility that the effect of the sealing is not sufficiently exhibited. When the sealing layer is formed with the sealing can, there is the possibility that the light emitting function of the organic EL device is adversely affected due to invasion of an adhesive into the inside of the device or generation of gases from the adhesive since the sealing can is attached to the substrate with the adhesive. Moreover, it is not easy that the recent requirements for further reduction in the size and the thickness are satisfied.

A method of sealing the portion of a light emitting substance of an organic EL device using a thermally adhesive plastic film exhibiting an excellent property for preventing moisture such as a film of a fluororesin in place of the sealing can, is attempted. However, in accordance with this method, the film of a fluororesin is expensive, and it is necessary for effectively exhibiting the effect of preventing moisture that the thickness of the film be large. As the result, the transparency (the transmittance of light) of the film itself decreases, and it is difficult that the light emitting ability of the light emitting substance of the organic EL device is sufficiently utilized.

The present invention has an object of providing a cover film for organic EL devices which overcomes the drawbacks in the conventional technologies for sealing organic EL devices, suppresses degradation of the organic EL device with oxygen and water in the environment so that the light emitting function of the organic EL device is effectively exhibited, gives the emission of light at the side of the cathode and can satisfy the requirements for decreasing the size and the thickness; an organic EL device comprising the cover film; and a process for efficiently producing the organic EL device.

### DISCLOSURE OF THE INVENTION

As the result of extensive studies by the present inventors to achieve the above object, it was found that a film comprising polymers of decomposition products of a perfluoroolefin and exhibiting excellent transparency could be easily formed on a transparent electrode of an organic EL device by disposing a transparent electrode layer as the cathode of the organic EL device and conducting the chemical vapor deposition (CVD) process under a specific condition of dissociation by electric discharge, and the formed film was useful as the cover film for organic EL devices. The present invention has been conducted based on this knowledge.

The present invention provides:
(1) A cover film for organic electroluminescence devices which comprises polymers of decomposition products of a perfluoroolefin and has an average light transmittance of 70% or larger in a wavelength band of 400 to 800 nm,
(2) A cover film for organic electroluminescence devices according to (1), wherein the perfluoroolefin is a perfluorocycloolefin,
(3) An organic electroluminescence device which comprises at least an electrode layer (an anode), a layer of a light emitting substance, a transparent electrode layer (a cathode) and a cover film for electroluminescence devices described in any one of (1) and (2), said layers and said film being laminated successively on a substrate,
(4) An organic electroluminescence device according to (3), wherein light is emitted mainly at a side of the cathode (the transparent electrode layer), and
(5) A process for producing an organic electroluminescence device which comprises forming a cover film on a laminate by depositing polymers of decomposition products of a perfluoroolefin in accordance with a chemical vapor deposition (CVD) process using a material gas comprising a perfluoroolefin as a main component under a condition of an output of 10 to 300 W and a pressure of the gas of 30 Pa or smaller, said laminate comprising at least an electrode layer, a layer of a light emitting substance and a transparent electrode layer, said layers being laminated successively on a substrate.

### BRIEF DESCRIPTION OF THE DRAWINGS

Figure 1 shows a diagram exhibiting the principle of an example of the organic EL device. Figure 2 shows a partial sectional view exhibiting the construction of an embodiment of the portion of a light emitting substance in the organic EL device of the present invention. Figure 3 shows a partial sectional view of a substrate in the organic EL device used in Example 2 and Comparative Example 2.

In the Figures, 1 means a transparent substrate, 1' means a substrate, 2 means a transparent electrode layer, 2' means an electrode layer, 3 means an insulation film, 4 means a resist pattern layer having an undercut profile, 5 and 5a mean organic EL material layers, 6 means a metal electrode layer, 6' and 6'a mean transparent electrode layers, 7 means a hole injecting and transporting layer, 8 means an organic light emitting layer, 9 means an electron injecting layer, 11 means a glass plate, 12 means a chromium electrode layer, 12 means a light shielding film, and 14 means a resin separation layer having an undercut profile.

### THE MOST PREFERRED EMBODIMENT TO CARRY OUT THE INVENTION

The cover film for organic EL devices of the present invention comprises polymers of decomposition products of a perfluoroolefin and has an excellent transparency such that the average light transmittance in a wavelength band of 400 to 800 nm (the entire range of visible light) is 70% or larger, preferably 80% or larger and more preferably 90% or larger. By disposing the cover film on the transparent electrode layer (the cathode) of an organic EL device, the emitted light can be efficiently obtained mainly at the side of the cathode, and degradation of the device with oxygen and water and generation and growth of dark spots are suppressed. Thus, the light emitting function of the device can be effectively exhibited

The cover film can be formed on the transparent electrode layer (the cathode) of the organic EL device using a material gas comprising a perfluoroolefin as the main component in accordance with the CVD process under a prescribed condition of dissociation by electric discharge. The formation of the cover film will be described specifically in the description for the process for producing an organic EL device later.

The thickness of the cover film for organic EL devices is not particularly limited. For surely obtaining the strength of the film and preventing moisture, the thickness is selected, in general, in the range of 0.01 to 10 µm, preferably in the range of 0.05 to 8 µm and more preferably in the range of 0.1 to 5 µm.

The organic EL device of the present invention has a construction in which at least an electrode layer (the anode), a layer of a light emitting substance, a transparent electrode layer (the cathode) and the cover film described above are laminated successively on a substrate.

The substrate may be any of a transparent substrate and an opaque substrate. In general, a flat and smooth substrate having a light transmittance of 50% or larger in the visible region of 400 to 800 nm is used. Examples of the substrate include glass plates and polymer plates. Examples of the glass plate include plates of soda lime glass, glass containing barium and strontium, lead glass, aluminosilicate glass, borosilicate glass, barium borosilicate glass and quartz. Examples of the polymer plate include plates of polycarbonates, acrylic resins, polyethylene terephthalate, polyether sulfide and polysulfone. Among these transparent substrates, in general, glass plates are preferable.

The portion of a light emitting substance of the organic EL device of the present invention comprises an anode formed on the above substrate, a organic EL material layer (such as a hole injecting and transporting layer, an organic light emitting layer and an electron injecting layer) and a cathode. The basic construction is an anode / an organic light emitting layer / a cathode. Other layers such as a hole injecting and transporting layer and an electron injecting layer can be suitably formed based on the basic construction, and the construction may be, for example, an anode / a hole injecting and transporting layer / an organic light emitting layer / a cathode or an anode / a hole injecting and transporting layer / an organic light emitting layer / an electron injecting layer / a cathode.

The organic EL device in which the portion of a light emitting substance has the construction of an anode / a hole injecting and transporting layer / an organic light emitting layer / an electron injecting layer / a cathode will be described more specifically in the following.

As the anode, an electrode using a metal, an alloy, an electrically conductive compound or a mixture of these materials which has a large work function (4 eV or larger) as the electrode material, is preferable. It is not always necessary that the electrode material used for the electrode is transparent. The electrode material may be a material having a large reflectivity or a material coated with a black carbon layer. As the material used for the electrode, a suitable material can be selected from, for example, metals having a high melting point such as chromium, tungsten, tantalum and niobium and alloys thereof, which have a reflectivity of 40% or larger, and transparent electrically conductive materials such as ITO (indium tin oxide), SnO₂, ZnO and In-Zn-O in accordance with the application of the device. When the emitted light is obtained efficiently at the side of the cathode, the metal having a reflectivity of 40% or larger and a high melting point is preferable. When the entire device is made transparent and a desired color is used for the background so that the display is colorful even when the light is not emitted, it is preferable a transparent electrically conductive material such as ITO is used as the electrode material. In this case, a transparent substrate is used. When the contrast is enhanced, it is advantageous that an electrode material coated with a black carbon layer is used.

It is preferable that the sheet resistance of the anode is several hundred Ω/□ or smaller. For forming the anode, a thin film is formed from the electrode material in accordance with the vapor deposition process or the sputtering process. The thickness of the anode is selected, in general, in the range of 10 nm to 1 µm and preferably in the range of 10 to 200 nm although the thickness depends on the type of the material.

The organic light emitting layer has the following functions: (1) the injecting function, i.e., injecting holes from the anode or the hole injecting and transporting layer and injecting electrons from the cathode or the electron injecting layer under application of an electric field; (2) the transporting function, i.e., transporting the injected charges (electrons and holes) by the force of the electric field; and (3) the light emitting function, i.e., providing the field for recombination of electrons and holes within the light emitting layer and leading the recombination to light emission. The light emitting material used for the light emitting layer is not particularly limited and a material conventionally used as the light emitting material in organic EL devices can be used. Examples of the light emitting material include fluorescent whitening agents such as benzothiazole-based agents, benzimidazole-based agents and benzoxazole-based agents; metal chelate oxinoid compounds; styrylbenzene-based compounds; distyrylpyrazine derivatives; and aromatic dimethylidine compounds.

The hole injecting and transporting layer is a layer comprising a hole transporting compound and has the function of transporting holes injected from the anode to the light emitting layer. By disposing the hole injecting and transporting layer between the anode and the light emitting layer, a larger amount of holes are injected into the light emitting layer under a lower electric field. Moreover, electrons injected from the cathode or the electron injecting layer into the light emitting layer are accumulated in the vicinity of the interface of the light emitting layer and the hole injecting and transporting layer in the light emitting layer due to the barrier for electrons existing at the interface. Thus, the efficiency of light emission of the organic EL device is improved, and the EL device exhibiting the excellent light emitting property can be prepared. The hole transporting compound used in the hole injecting and transporting layer is not particularly limited, and conventional compounds used heretofore as the hole transporting compound in organic EL devices can be used. Example of the hole transporting compound include triazole derivatives, oxadiazole derivatives, imidazole derivatives, polyarylalkane derivatives, pyrazoline derivatives, pyrazolone derivatives, phenylenediamine derivatives, arylamine derivatives, amino-substituted chalcone derivatives, oxazole derivatives, styrylanthracene derivatives, fluorenone derivatives, hydrazone derivatives, stilbene derivatives, silazane derivatives, polysilane derivatives, aniline-based copolymers and specific electrically conductive macromolecular oligomers such as thiophene oligomers.

The electron injecting layer has the function of transporting electrons injected from the cathode to the organic light emitting layer. The electron transporting compound used in the electron injecting layer is not particularly limited, and conventional compounds used heretofore as the electron transporting compound in organic EL devices can be used. Example of the electron transporting compound include nitro-substituted fluorenone derivatives, anthraquinodimethane derivatives, diphenyl-quinone derivatives, thiopyrane dioxide derivatives, heterocyclic tetracarboxylic acid anhydrides such as corresponding compounds having naphthalene ring or perylene ring, carbodiimides, fluorenylidenemethane derivatives, anthrone derivatives, oxadiazole derivatives and metal complexes of 8-quinolinol and derivatives thereof. Examples of the metal complex of 8-quinolinol and the derivative thereof include tris(8-quinolinol)aluminum, bis(8-quinolinol)magnesium, bis(benzo-8-quinolinol)zinc, bis(2-methyl-8-quinolylato)aluminum oxide, tris(8-quinolinol)indium, tris(5-methyl-8-quinolinol)aluminum, 8-quinolinol-lithium, tris(5-chloro-8-quinolinol)potassium, bis(5-chloro-8-quinolinol)-calcium, tris(5,7-dichloro-8-quinolinol)aluminum, tris(5,7-dibromo-8-quinolinol)aluminum, bis(8-quinolinol)beryllium, bis(2-methyl-8-quinolinol)beryllium, bis(8-quinolinol)zinc, bis(2-methyl-8-quinolinol)zinc, bis(8-quinolinol)tin and tris(7-propyl-8-quinolinol)aluminum.

The organic light emitting layer, the hole injecting and transporting layer and the electron injecting layer may be constituted with a single layer comprising at least one material for the layer or may be a laminate of at least two layers each comprising different materials.

The hole injecting and transporting layer, the organic light emitting layer and the electron injecting layer described above can be prepared by forming the materials constituting the layers into thin films. Examples of the process for preparing the thin film include the spin coating process, the casting process and the vapor deposition process. The vacuum vapor deposition process is preferable since a uniform thin film is easily obtained and formation of pin holes is suppressed. When the vapor deposition process is used for forming the thin film, the condition of the vapor deposition is different depending on the type of the compound used for the vapor deposition and the crystal structure and the association structure of the molecular deposition film to be formed. In general, it is preferable that the conditions are suitably selected in the following ranges: the temperature of the heated boat: 50 to 450°C; the degree of vacuum: 1×10⁻⁵ to 1×10⁻¹ Pa; the rate of vapor deposition: 0.01 to 50 nm/sec; the temperature of the substrate: -50 to 300°C; and the thickness of the layer: 5 nm to 1 µm.

As the cathode, a transparent electrode layer comprising a metal, an alloy, an electrically conductive compound or a mixture of the substances as the electrode material can be used. As the transparent electrode layer, a layer which is constituted with an electron injecting metal layer and an amorphous transparent conductive layer and adjacent to the electron injecting layer is preferable.

The amorphous transparent conductive layer is not particularly limited as long as the layer is amorphous, transparent and electrically conductive. It is preferable that the electric resistance is 5×10⁻⁴ Ω.cm or smaller. Preferable examples of the material thereof include In-Zn-O-based oxide films. The thickness of the film is, in general, in the range of 10 nm to 1 µm and preferably in the range of 50 to 200 nm. The electron injecting metal layer is a layer of a metal which can excellently inject electrons into the organic light emitting layer via the electron injecting layer. To efficiently obtain the emitted light at the side of the cathode, it is preferable that the average light transmittance in a wavelength band of 400 to 800 nm is 50% or larger and more preferably 60% or larger. To achieve the light transmittance, it is preferable that the thickness of the electron injecting metal layer is adjusted at a very small value in the range of about 0.5 to 20 nm and more preferably in the range of 1 to 20 nm. Examples of the metal for the electron injecting metal layer include metals having a small work function (4 eV or smaller) such as Mg, Mg·Ag alloys, Ca, Ba, Sr, Li, Yb, Eu, Y and Sc.

The cathode can be prepared, using the above electrode materials, by forming the electron injecting metal layer on the above electron injecting layer in accordance with the vapor deposition process or the sputtering process, followed by laminating the amorphous transparent conductive layer on the formed electron injection metal layer. It is preferable that the cathode has a sheet resistance of several hundred Ω/□ or smaller.

The organic EL device of the present invention can be obtained by forming a transparent cover film comprising polymers of decomposition products of a perfluoroolefin described above on the portion of a light emitting substance which is formed on the substrate and comprises the electrode layer (the anode), the organic EL material layer and the transparent electrode layer (the cathode). An embodiment of the process for producing the portion of a light emitting substance described above will be described in the following.

A patterned electrode layer (an anode) is formed on a substrate such as a glass plate in accordance with a process such as the vapor deposition process and the sputtering process. On the formed layer, an insulation film having a thickness, in general, in the range of 0.1 to 10 µm, preferably in the range of 0.1 to 5 µm and more preferably in the range of 0.5 to 2 µm is formed in accordance with a conventional process. The insulation film may be a conventional film of a polyimide resin. Alternatively, in order that the insulation film works also as the light shielding film, the film may be formed in accordance with the lithography using (1) a resist for forming a light shielding film which comprises in a solvent an organic pigment comprising a quasi-black mixed color organic pigment prepared by mixing at least two organic pigments selected from black organic pigments and/or pigments selected from red, blue, green, violet, yellow, cyan and magenta pigments, at least one light shielding material selected from carbon black, chromium oxide, iron oxide, titanium black and aniline black and a light-sensitive resin, or (2) a resist for forming a light shielding film which comprises a resin soluble in an alkali, a quinone diazide compound, a black pigment and a solvent.

Via the insulation film formed on the substrate as described above, a resist pattern layer is formed in accordance with a conventional process. The sectional shape of the resist pattern layer may be a rectangular profile or an undercut profile.

When the resist pattern layer having a rectangular sectional shape is formed, the photoresist used for forming the layer may be any of the non-chemical amplification type and the chemical amplification type and may be any of the positive type and the negative type. Examples of the photoresist include (1) positive type photoresists of the non-chemical amplification type which comprise a novolak-type resin soluble in an alkali and a compound having quinone diazide group as the essential components, (2) positive type photoresists of the chemical amplification type which comprise a resin exhibiting change in solubility in an alkali by the action of an acid and a compound generating an acid by irradiation with a radiation as the essential components, and (3) negative type photoresists of the chemical amplification type which comprise a resin soluble in an alkali, a substance crosslinked with an acid and a compound generating an acid by irradiation with a radiation as the essential components. When the resist pattern layer having an undercut profile is formed, a photoresist such as that described in Japanese Patent No. 2989064 can be used. Examples of this photoresist include a negative type photoresist which comprises at least one of (A) a component crosslinked by exposure to light or by exposure to light, followed by a heat treatment, (B) a resin soluble in an alkali and (C) a compound which absorbs the light used for the exposure and is developed with an alkaline aqueous solution.

The process for forming the resist pattern layer using the above photoresist is not particularly limited, and the resist pattern layer having the rectangular profile or the undercut profile can be formed in accordance with the conventional lithography. The thickness of the resist pattern layer is, in general, about 0.5 to several µm.

After the resist pattern layer is formed on the substrate having the patterned electrode layer via the insulation film as described above, a hole injecting and transporting layer is formed in accordance with the vacuum vapor deposition. The conditions for the vacuum vapor deposition are different depending on the used compound (the material of the hole injecting and transporting layer) and the crystal structure and the recombination structure of the hole injecting and transporting layer to be formed. In general, it is preferable that the conditions are suitably selected in the following ranges: the temperature of the source of vapor deposition: 50 to 450°C; the degree of vacuum: 1×10⁻⁵ to 1×10⁻¹ Pa; the rate of vapor deposition: 0.01 to 50 nm/sec; the temperature of the substrate: -50 to 300°C; and the thickness of the layer: 5 nm to 1 µm.

In the next step, an organic light emitting layer is formed on the hole injecting and transporting layer in accordance with the vacuum vapor deposition. In general, the conditions for the vacuum vapor deposition can be selected in the same ranges as those described for the formation of the hole injecting and transporting layer although the conditions are different depending on the compounds used for the vacuum vapor deposition. It is preferable that the thickness of the layer is in the range of 10 to 40 nm.

On the organic light emitting layer thus formed, an electron injecting layer is formed in accordance with the vacuum vapor deposition. The conditions for the vacuum vapor deposition can be selected in the same ranges as those described for the formation of the hole injecting and transporting layer and the formation of the light emitting layer. It is preferable that the thickness of the layer is in the range of 5 nm to 1 µm.

As the final step, a transparent electrode (a cathode) is prepared by laminating, on the electron injecting layer, an electron injecting metal layer having a thickness of about 1 to 20 nm in accordance with the vacuum vapor deposition process and an amorphous transparent conductive layer having a thickness of about 50 to 200 nm in accordance with the sputtering process.

The laminate (the portion of a light emitting substance) comprising the electrode layer (the anode), the organic EL material layer (the hole injecting and transporting layer, the organic light emitting layer and the electron injecting layer) and the transparent electrode layer (the cathode) on the substrate is formed as described above.

Figure 2 shows a sectional view exhibiting the construction of an embodiment of the portion of a light emitting substance in the organic EL device of the present invention. On a substrate 1' having a patterned electrode layer 2', a resist pattern layer (a resin separation layers) 4 having an undercut profile is disposed via the insulation film 3. Between the patterns of the resist pattern layer, an organic EL material layer 5 (having the construction in which a hole injecting and transporting layer, an organic light emitting layer and an electron injecting layer are successively formed from the side of the transparent electrode layer) having a transparent electrode layer 6' on the surface is disposed. The portion of a light emitting substance is disposed independently without having contacts with the resist pattern layer. On the resist pattern 4, an organic EL material layer 5a having a transparent electrode layer 6'a is formed due to convenience in the preparation although these layers are not necessary from the standpoint of the function.

In the present invention, the cover film comprising polymers of decomposition products of a perfluoroolefin is formed on the laminate comprising the electrode layer, the organic EL material layer and the transparent electrode layer successively formed on the substrate using a material gas comprising the perfluoroolefin as the main component under the condition of an output of 10 to 300 W and a gas pressure of 30 Pa or smaller in accordance with the CVD process (referred to as the plasma CVD process, hereinafter), and a sealed organic EL device is prepared.

The material gas comprising a perfluoroolefin as the main component (occasionally, referred to simply as the "material gas", hereinafter) means a material gas in which the reactive component (the component contributing to the decomposition and the polymerization) is substantially the perfluoroolefin alone. Examples of the perfluoroolefin include linear and branched perfluoroolefins and perfluorocycloolefins. Into the material gas, where desired, dilution gases, for example, rare gases such as argon, helium and xenon and gases of hydrocarbons such as methane, ethylene and acetylene, may be mixed. However, it is preferable that the perfluoroolefin is used singly from the standpoint of the easiness of the temperature control during the vapor deposition.

The number of the carbon atom in the perfluoroolefin is not particularly limited. In general, the number of the carbon atom is 3 to 8, preferably 4 to 6 and more preferably 5. The perfluoroolefin may have any of the linear, branched and cyclic structures. The cyclic structure is preferable from the standpoint of safety and transparency of the film. The perfluoroolefin may be used singly or in combination of two or more types. It is preferable that at least one perfluorocycloolefin is used.

When a perfluorocycloolefin and a linear or branched perfluoroolefin are used in combination, a particularly excellent effect of preventing moisture can be obtained when the amount of the linear or branched perfluoroolefin is, in general, 30% by weight or less and preferably 20% by weight or less based on the amount of the entire perfluoroolefins.

Examples of the linear or branched perfluoroolefin include perfluoropropene, perfluorobutene, perfluoropentene and perfluoro-2-methylbutene. Examples of the perfluorocycloolefin include perfluorocyclopropene, perfluorocyclobutene, perfluorocyclopentene, perfluorocyclohexene, perfluorocycloheptene, perfluorocyclooctene, perfluoro(1-methylcyclobutene), perffuoro(3-methylcyclobutene), perfluoro(1-methylcyclopentene) and perfluoro(3-methylcyclopentene). Among these compounds, perfluorocycloolefins such as perfluorocyclobutene, perfluorocyclopentene and perfluorocyclohexene are preferable, and perfluorocyclopentene is most preferable.

As the procedures in the plasma CVD process, the procedures described, for example, in Japanese Patent Application Laid-Open No. Heisei 9(1997)-237783 can be used. In the present invention, it is preferable that the output as the radio frequency (RF) is 10 to 300 W and more preferably 50 to 250 W, the gas pressure is 30 Pa or smaller, preferably 1×10⁻² to 30 Pa and more preferably 1 to 25 Pa and most preferably 1 to 20 Pa so that the cover film comprising polymers of decomposition products of the perfluoroolefin which exhibits excellent transparency such that the average light transmittance in a wavelength band of 400 to 800 nm is 70% or larger, preferably 80% or larger and more preferably 90% or larger, can be obtained.

The flow rate of the perfluoroolefin in the CVD process is not particularly limited. The flow rate is, in general, in the range of 1 to 100 cm³/min, preferably in the range of 1 to 50 cm³/min and more preferably in the range of 5 to 30 cm³/min under the standard condition. When the flow rate exceeds the above range, etching of the cathode with the gas occasionally takes place. When the flow rate is smaller than the above range, productivity becomes poor.

The cover film comprising polymers of decomposition products of a perfluoroolefin prepared as described above has a thickness, in general, in the range of 0.01 to 10 µm, preferably in the range of 0.05 to 8 µm and more preferably in the range of 0.1 to 5 µm, as described above. The cover film having the desired thickness can be prepared by changing the flow rate and/or the time of vapor deposition of the perfluoroolefin.

The temperature of the article to be treated by the CVD process is not particularly limited. The temperature is, in general, selected in the range of 0 to 500°C. Since the film can be prepared at a temperature of 100°C or lower and preferably 50°C or lower when the perfluoroolefin is used, the process is effective for increasing the production efficiency and suppressing damages to the substrate.

As the apparatus for the plasma CVD, in general, CVD apparatuses of the parallel flat plate type are used. Microwave CVD apparatuses, ECR-CVD apparatuses and high density plasma (such as helicon plasma and inductivity coupled plasma) CVD apparatuses can also be used.

Irradiation with ultraviolet light from a low pressure mercury lamp may be conducted to promote dissociation of the material gas and decrease damages on the article to be treated. The article to be treated and the space of the reaction may be irradiated with ultrasonic wave to promote migration of the perfluoroolefin.

As described above, the cover film comprising polymers of decomposition products of the perfluoroolefin which exhibits excellent transparency is formed on the transparent electrode layer (the cathode) of the organic EL device, and the sealed organic EL device of the present invention can be obtained.

### EXAMPLES

The present invention will be described more specifically with reference to examples in the following. However, the present invention is not limited to the examples.

### Example 1

A resin substrate having a total light transmittance of visible light of 92.5%, a haze of 0.75% and a thickness of 100 µm was fixed at a plasma CVD apparatus of the parallel flat plate type. The plasma CVD was conducted for 6 minutes under the following condition, and a transparent cover film having a thickness of 2 µm was formed on the resin substrate.

| | |
|---|---|
| Flow rate of perfluorocyclopentene | 15 cm³/min |
| | (standard condition) |
| Gas pressure | 13 Pa |
| RF output (the frequency: 13.53 MHz) | 200 W |
| Temperature of the substrate | 25±3°C |

No cracks or voids were found on the obtained cover film. The light transmittance in the entire range of visible light (light having the wavelength in the range of 400 to 800 nm) of the resin substrate having the cover film was measured using a UV/VIS/NIR spectrometer [manufactured by JASCO Co., Ltd.]. The transmittance was found to be 85% or larger at any wavelength in the range of 400 to 800 nm, and the average transmittance was 92.1%. The haze measured by a turbidimeter [manufactured by NIPPON DENSHOKU KOGYO Co., Ltd.] was 0.77%.

### Comparative Example 1

A cover film having a thickness of 2 µm was formed on a resin substrate in accordance with the same procedures as those conducted in Example 1 except that, in the condition of the plasma CVD process, the gas pressure was changed to 1.3 Pa and the RF output (the frequency: 13.53 MHz) was changed to 400 W. As the result, the light transmittance in the entire range of visible light was in the range of 8 to 30%, the average transmittance was 23.28%, and the haze was 76.10%.

### Example 2

### (1) Formation of a portion of a light emitting substance of an organic EL device

Figure 3 shows a partial sectional view of a substrate in the organic EL device used in the present Example. The substrate had a construction such that a resin separation layer having a thickness of 3.5 µm and having an undercut profile 14 was disposed on a glass plate 11 having a size of 25×75×1.1 mm and having a chromium electrode layer 12 patterned on the surface via a light shielding film 13 having a thickness of 1.0 µm.

The above substrate for an organic EL device was fixed at a substrate holder of a commercial vapor deposition apparatus [manufactured by NIPPON SHINKU GIJUTU Co., Ltd.]. Into a boat made of molybdenum and heated by resistance, 200 mg of N,N'-bis(3-methylphenyl)-N,N'-diphenyl-[l.l'-biphenyl]-4,4'-diamine (hereinafter, referred to as TPD) was placed, and 200 mg of 4,4'-bis- (2,2'-diphenyl-vinyl)biphenyl (hereinafter, referred to as DPVBi) was placed into another boat made of molybdenum and heated by resistance. The vacuum chamber was evacuated to 1×10⁻⁴ Pa.

TPD was vapor deposited at a rate of vapor deposition of 0.1 to 0.3 nm/sec by heating the boat containing TPD at 215 to 220°C, and a hole injecting and transporting layer having a thickness of 60 nm was formed. During this formation, the temperature of the substrate was kept at the room temperature. Without taking out the coated substrate, DPVBi was vapor deposited on the formed hole injecting and transporting layer at a rate of vapor deposition of 0.1 to 0.3 nm/sec by heating the boat containing DPVBi at 240°C, and a light emitting layer having a thickness of 40 nm was formed. During this formation, the temperature of the substrate was kept at the room temperature.

The resultant product was taken out of the vacuum chamber. After a mask made of stainless steel was placed on the light emitting layer formed above, the product was fixed at the substrate holder again. Into a boat made of molybdenum, 200 mg of tris(8-quinolinol)aluminum (hereinafter, referred to as Alq₃) was placed, and 1 g of magnesium ribbon was placed into another boat made of molybdenum. Into a basket made of tungsten, 500 mg of silver wire was placed. The boats and the basket were placed into the vacuum chamber.

After the vacuum chamber was evacuated to 1×10⁻⁴ Pa, Alq₃ was vapor deposited on the light emitting layer formed above at a rate of vapor deposition of 0.01 to 0.03 nm/sec by heating the boat containing Alq₃ at 230°C, and an electron injecting layer having a thickness of 20 nm was formed. On the formed electron injecting layer, silver was vapor deposited at a rate of vapor deposition of 0.01 nm/sec and, simultaneously, magnesium was vapor deposited at a rate of vapor deposition of 0.14 nm/sec. Thus, an electron injecting metal layer composed of a mixed metal of magnesium and silver and having a thickness of 10 nm was formed.

The laminate prepared above was transferred to another vacuum chamber, and an In-Zn-O-based amorphous transparent conductive layer having a thickness of 200 nm was formed on the electron injecting metal layer through the same mask in accordance with the DC sputtering process. The DC sputtering process was conducted under the condition of a pressure of 0.3 Pa and a DC output of 40 W using a mixed gas of argon and oxygen (the ratio of the amounts by volume: 1,000:5) as the sputter gas.

A transparent electrode layer (the cathode) constituted with an electron injecting metal layer and an amorphous transparent conductive layer were formed, and thus the portion of a light emitting substance of an organic EL device was formed.

### (2) Preparation of an organic EL device

Using as the substrate the glass plate having the portion of a light emitting substance of an organic EL device at the surface which was obtained in (1) described above, a cover film having a thickness of 2 µm was formed on the transparent electrode layer (the cathode) in accordance with the same procedures as those conducted in Example 1. No cracks or voids were found on the cover film, and the cover film was dense and uniform.

A sealed organic EL device was prepared as described above.

### (3) Evaluation of the organic EL device

The organic EL device obtained in (2) described above was subjected to a test of leaving standing under an environment of 40°C and 90% RH for 10,000 hours. Before and after the test, a direct voltage was applied to the device using the chromium electrode layer as the anode (the positive electrode) and the transparent electrode as the cathode (the negative electrode). In the evaluations both before and after the test, the emission of blue light was confirmed at the side of the cathode under the bright condition at a voltage of 5 V or larger, and it is shown that the self-distinguishability was excellent. No dark spots were found on the face of light emission, and the light emission was uniform. In other words, it was found that the test caused almost no damages to the organic EL device.

### Comparative Example 2

### (1) A portion of a light emitting substance of an organic EL device was formed in accordance with the same procedures as those conducted in Example 1.

### (2) Preparation of an organic EL device

Using the glass plate having the portion of a light emitting substance of an organic EL device at the surface which was obtained in (1) described above, a cover film having a thickness of 2 µm was formed on the transparent electrode layer (the cathode), and a sealed organic EL device was prepared in accordance with the same procedures as those conducted in Comparative Example 1.

### (3) Evaluation of an organic EL device

A direct voltage was applied to the sealed device obtained in (2) described above using the chromium electrode layer as the anode (the positive electrode) and the transparent electrode as the cathode (the negative electrode) in a manner similar to that in Example 2. A vague emission of blue light was found at the side of the cathode, and the self-distinguishability was markedly inferior to that in Example 2.

### INDUSTRIAL APPLICABILITY

The cover film for organic EL devices of the present invention comprises polymers of decomposition products of a perfluoroolefin and exhibits excellent transparency. Degradation of the device with oxygen and water in the environment is suppressed, and the light emitting function of the organic EL device can be effectively exhibited. The cover film is advantageously used for obtaining the emitted light at the side of the cathode and also for decreasing the size and the thickness of the device.

## Claims

1. A cover film for organic electroluminescence devices which comprises polymers of decomposition products of a perfluoroolefin and has an average light transmittance of 70% or larger in a wavelength band of 400 to 800 nm.

2. A cover film for organic electroluminescence devices according to Claim 1, wherein the perfluoroolefin is a perfluorocycloolefin.

3. An organic electroluminescence device which comprises at least an electrode layer (an anode), a layer of a light emitting substance, a transparent electrode layer (a cathode) and a cover film for electroluminescence devices described in any one of Claims 1 and 2, said layers and said film being laminated successively on a substrate.

4. An organic electroluminescence device according to Claim 3, wherein light is emitted mainly at a side of the cathode (the transparent electrode layer).

5. A process for producing an organic electroluminescence device which comprises forming a cover film on a laminate by depositing polymers of decomposition products of a perfluoroolefin in accordance with a chemical vapor deposition (CVD) process using a material gas comprising a perfluoroolefin as a main component under a condition of an output of 10 to 300 W and a pressure of the gas of 30 Pa or smaller, said laminate comprising at least an electrode layer, a layer of a light emitting substance and a transparent electrode layer, said layers being laminated successively on a substrate.
